(19) Europäisches Patentamt
European Patent Office
Office européen des brevets

(11) **EP 4 113 778 B1**

(12) **EUROPEAN PATENT SPECIFICATION**

(45) Date of publication and mention
of the grant of the patent:
**31.07.2024   Bulletin 2024/31**

(21) Application number: **21761007.0**

(22) Date of filing: **29.01.2021**

(51) International Patent Classification (IPC):
*H02J 7/00* (2006.01)   *H02J 50/05* (2016.01)
*H02J 50/90* (2016.01)   *H02J 7/02* (2016.01)
*H02J 50/00* (2016.01)   *G01R 27/26* (2006.01)

(52) Cooperative Patent Classification (CPC):
**H02J 50/05; H02J 7/0042; H02J 7/02;
H02J 50/005; H02J 50/90;** G01R 27/2605;
Y02B 40/00

(86) International application number:
**PCT/CN2021/074421**

(87) International publication number:
**WO 2021/169729 (02.09.2021 Gazette 2021/35)**

(54) **CIRCUIT CONTROL APPARATUS AND METHOD**

SCHALTUNGSSTEUERVORRICHTUNG UND VERFAHREN

APPAREIL ET PROCÉDÉ DE COMMANDE DE CIRCUIT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **27.02.2020   CN 202010124364**

(43) Date of publication of application:
**04.01.2023   Bulletin 2023/01**

(73) Proprietor: **Vivo Mobile Communication Co., Ltd.
Dongguan, Guangdong 523863 (CN)**

(72) Inventors:
• **SONG, Yalei
Dongguan, Guangdong 523863 (CN)**

• **ZHANG, Wencheng
Dongguan, Guangdong 523863 (CN)**

(74) Representative: **Raffay & Fleck
Patentanwälte
Grosse Bleichen 8
20354 Hamburg (DE)**

(56) References cited:
CN-A- 104 124 773     CN-A- 105 226 764
CN-A- 105 226 764     CN-A- 106 569 648
CN-A- 106 569 648     CN-A- 107 706 981
CN-A- 107 846 084     CN-A- 111 245 055
CN-A- 112 039 228     CN-U- 208 076 736
US-A1- 2012 235 508   US-A1- 2017 063 136

## Description

## TECHNICAL FIELD

The present invention relates to the field of computer technologies, and in particular, to a circuit control apparatus and method.

## BACKGROUND

With the rapid development of computer technologies, more and more electronic devices, mainly mobile phones, are applied to people's daily life. To meet people's increasing demand for convenience and practicability, electronic devices can provide users with increasingly more functions, such as a wireless charging function and a capacitance detection function.

An electronic device may be equipped with a wireless charging function module, and a wireless charging loop may be formed through two configured wireless charging capacitor polar plates and a charging device (for example a wireless charging base), to wirelessly charge the electronic device. In addition, the electronic device may be further equipped with a capacitance detection function module, to detect a capacitance change between an external dielectric object and the electronic device through a configured capacitance detection polar plate, and enable or disable a corresponding function according to the capacitance change. For example, when it is detected that a capacitance value between the external dielectric object and the electronic device is smaller than a preset capacitance threshold, a screen-off function may be enabled.

However, the wireless charging capacitor polar plates and the capacitance detection polar plate have large areas and occupy a lot of space in the electronic device, there may be stacking of the devices. Moreover, since the working voltage of the electronic device is relatively high during wireless charging, the stacking of the devices causes safety hazards, resulting in poor safety of the electronic device.

US20120235508A1 provides a non-contact power transmission system, which comprises: a primary coil including a power supply coil and a magnetic resonance coil; and a secondary coil including a load coil, thereby transmitting an electric power from the power supply coil at a self-resonating frequency of the magnetic resonance coil, which is determined by a parasitic capacitance between wound wires of the coil and a self-inductance of the coil, and taking out the electric power supplied, from the load coil of the secondary coil through magnetic coupling, with non-contact, wherein the electric power is transmitted, with non-contact, with applying magnetic coupling in coupling between the power supply coil and the magnetic resonance coil and coupling between the magnetic resonance coil and the load coil.

CN106569648A discloses mobile equipment and a mobile equipment control method. A fixed capacitance polar plate is arranged below a rear shell at the back of the mobile equipment; the fixed capacitance polar plate and an operation object, which is positioned outside the rear shell and used as a movable capacitance polar plate, form a capacitor; the capacitance value of the capacitor, which is composed of the fixed capacitance polar plate below the rear shell and the operation object, is detected through a detection circuit; and a controller generates a control instruction for controlling the mobile equipment according to the detected capacitance value and the pre-set capacitance value and control instruction corresponding relationship.

## SUMMARY

An objective of embodiments of the present invention is to provide a circuit control apparatus and method, to resolve the problem of poor safety of an electronic device due to stacking of wireless charging capacitor polar plates and a capacitance detection polar plate in the electronic device in the related art.

The embodiments in the present disclosure, even labelled as invention, do not necessarily define the scope of the invention. The invention is solely defined by the features of the independent claims. Preferred embodiments are defined in the dependent claims.

To resolve the foregoing technical problem, the embodiments of the present invention are implemented as follows:

According to a first aspect, an embodiment of the present invention provides a circuit control apparatus as described in claim 1.

The circuit control apparatus is applied to an electronic device. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device wherein the charging device is an external dielectric object; and in a case that the first common end and the third end are electrically connected, the capacitance detection module obtains a first capacitance value through the first polar plate.

Moreover, the circuit control apparatus further includes a first shielding structural member, where the first polar plate and the first shielding structural member are spaced apart and distributed opposite to each other, and the first shielding structural member is electrically connected to the capacitance detection module; and in a case that the first common end and the third end are electrically connected, the capacitance detection module obtains the first capacitance value through the first polar plate and the first shielding structural member.

Optionally, the circuit control apparatus further includes a third polar plate, where the third polar plate is electrically connected to the charging control module; and in a case that the first common end and the second end are electrically connected, the charging control module performs wireless charging through the first polar plate, the third polar plate, the second polar plate of the charging device, and a fourth polar plate of the charging device.

Optionally, the circuit control apparatus further includes a second switch, where the second switch includes a second common end, a fourth end, and a fifth end, the third polar plate is electrically connected to the second common end, the fourth end is electrically connected to the charging control module, and the fifth end is electrically connected to the capacitance detection module; in a case that the first common end and the second end are electrically connected, and the second common end and the fourth end are electrically connected, the charging control module performs wireless charging through the first polar plate, the third polar plate, the second polar plate of the charging device, and the fourth polar plate of the charging device; and in a case that the second common end and the fifth end are electrically connected, the capacitance detection module obtains a second capacitance value through the third polar plate.

Optionally, the circuit control apparatus further includes a second shielding structural member, where the third polar plate and the second shielding structural member are spaced apart and distributed opposite to each other, and the second shielding structural member is electrically connected to the capacitance detection module; and in a case that the second common end and the fifth end are electrically connected, the capacitance detection module obtains the second capacitance value through the third polar plate and the second shielding structural member.

Optionally, the circuit switching module is connected to the first switch, the second switch, and the capacitance detection module, and the circuit switching module is configured to control connection statuses of the first switch and the second switch according to the first capacitance value and/or the second capacitance value detected by the capacitance detection module.

According to a second aspect, an embodiment of the present invention provides a circuit control method as described in claim 7. The method is applied to the foregoing circuit control apparatus according to the first aspect. The method includes: controlling a first common end and a second end of a first switch to be electrically connected in a case that capacitance information acquired by a capacitance detection module satisfies a first preset condition; and controlling the first common end and a third end of the first switch to be electrically connected in a case that a charging current of a charging control module satisfies a second preset condition.

Optionally, the controlling a first common end and a second end of a first switch to be electrically connected in a case that capacitance information acquired by a capacitance detection module satisfies a first preset condition includes: in a case that the circuit control apparatus includes a first polar plate and a third polar plate, and a first capacitance value and/or a second capacitance value acquired by the capacitance detection module is not less than a preset capacitance threshold, controlling the first common end and the second end of the first switch to be electrically connected, and controlling a second common end and a fourth end of a second switch to be electrically connected.

Optionally, the controlling the first common end and a third end of the first switch to be electrically connected in a case that a charging current of a charging control module satisfies a second preset condition includes: controlling the first common end and the third end of the first switch to be electrically connected in a case that the charging current of the charging control module is not greater than a preset current threshold.

Optionally, the controlling the first common end and the third end of the first switch to be electrically connected in a case that the charging current of the charging control module is not greater than a preset current threshold includes: controlling the first common end and the third end of the first switch to be electrically connected in a case that the charging current of the charging control module is not greater than the preset current threshold within a preset detection time.

As can be learned from the technical solutions provided in the embodiments of the present invention, the embodiments of the present invention provide a circuit control apparatus and method. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device; and in a case that the first common end and the third end are electrically connected, the capacitance detection module obtains a first capacitance value through the first polar plate. By using the circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

## BRIEF DESCRIPTION OF THE DRAWINGS

To describe the technical solutions in the embodiments of the present invention or in the related art more clearly, the accompanying drawings required for describing the embodiments or the related art are briefly described. Apparently, the accompanying drawings in the following descriptions show only some embodiments described in the present invention, and a person of ordinary skill in the art may still derive other drawings from these accompanying drawings without creative efforts.

FIG. 1 is a schematic structural diagram of a circuit control apparatus according to the present invention;
FIG. 2 is a schematic diagram of a position of a first polar plate in an electronic device according to the present invention;
FIG. 3 is a schematic structural diagram of another circuit control apparatus according to the present invention;
FIG. 4 is a schematic diagram of positions of a first polar plate and a third polar plate in an electronic device according to the present invention;
FIG. 5 is a schematic structural diagram of another circuit control apparatus according to the present invention;
FIG. 6 is a schematic structural diagram of another circuit control apparatus according to the present invention;
FIG. 7 is a schematic structural diagram of another circuit control apparatus according to the present invention;
FIG. 8 is a flowchart of an embodiment of a circuit control method according to the present invention;
FIG. 9 is a flowchart of an embodiment of another circuit control method according to the present invention;
FIG. 10 is a schematic structural diagram of an embodiment of a circuit control apparatus according to the present invention; and
FIG. 11 is a schematic structural diagram of an embodiment of an electronic device according to the present invention.

Illustration of the drawings:

100: First polar plate; 200: First switch; 201: First common end; 202: Second end; 203: Third end; 300: Charging control module; 400: Capacitance detection module; 500: Circuit switching module; 600: Charging device; 601: Second polar plate; 602: Fourth polar plate; 700: First shielding structural member; 800: Third polar plate; 900: Second switch; 901: Second common end; 902: Fourth end; and 903: Fifth end.

## DETAILED DESCRIPTION

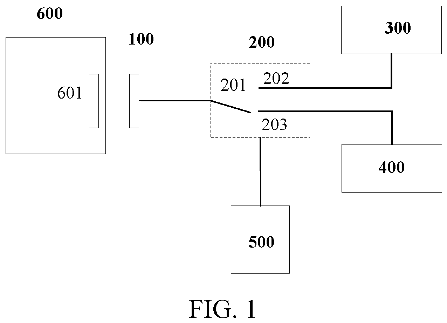

Embodiments of the present invention provide a circuit control apparatus and method.
To make a person skilled in the art better understand the technical solutions in the present invention, the technical solutions in the embodiments of the present invention are described clearly and completely with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention. However, the invention is defined by the features of the independent claims. Preferred embodiments are defined in the dependent claims.
An embodiment of the present invention provides a circuit control apparatus. As shown in FIG. 1, the circuit control apparatus includes a charging control module 300, a circuit switching module 500, a capacitance detection module 400, a first switch 200, and a first polar plate 100. The first polar plate 100 may be arranged in a predetermined region in which a capacitance change between an external dielectric object and an electronic device.
The external dielectric object is an object with dielectric properties such as a finger or a charging device 600 (for example, a wireless charging base). The first polar plate 100 may be configured to generate a corresponding capacitance change according to a change in a distance between the external dielectric object and the electronic device. Moreover, the first polar plate 100 may be further configured to form a wireless charging loop with a second polar plate 601 of the charging device 600, to wirelessly charge the electronic device. In addition, the first polar plate 100 may be further configured to enable or disable a function based on capacitance detection according to the distance between the external dielectric object and the electronic device. The first polar plate 100 may be one or more capacitance detection polar plates, that is, the first polar plate 100 may be used as a wireless charging capacitor polar plate, or may be used as a capacitance detection polar plate. The predetermined region may be a region that enables the first polar plate 100 to detect the capacitance change between the external dielectric object and the electronic device. For example, the predetermined region may be a middle region of a back surface of the electronic device (that is, a side surface on which a rear-facing camera is located), or the predetermined area may be a right region of the top of the electronic device, or the predetermined region may be an upper region of a side surface of the electronic device, or the like.

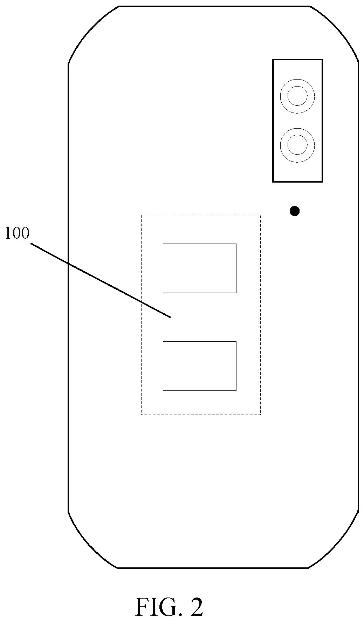

For example, as shown in FIG. 2, the first polar plate 100 may include two capacitor polar plates, which may be arranged in the middle region of the back surface of the electronic device to detect the capacitance change between the external dielectric object and (the back surface of) the electronic device.

In addition, the capacitance change between the external dielectric object and the electronic device may be alternatively obtained by detecting a change in a voltage difference of the first polar plate 100. A capacitance C between the external dielectric object and the electronic device is a ratio of a charge amount Q to a voltage difference U (that is, a voltage difference between the external dielectric object and the electronic device). Therefore, in a case that the charge amount Q remains unchanged, the capacitance change between the external dielectric object and the electronic device may be obtained according to the detected change in the voltage difference of the first polar plate 100.

The first switch 200 may include a first common end 201, a second end 202, and a third end 203. The first polar plate 100 may be electrically connected to the first common end 201. The charging control module 300 may be electrically connected to the second end 202. The capacitance detection module 400 may be electrically connected to the third end 203.

The circuit switching module 500 may be configured to control a connection status of the first switch 200.

In a case that the first common end 201 and the second end 202 are electrically connected, the charging control module 300 may perform charging through the first polar plate 100 and the second polar plate 601 of the charging device 600.

In a case that the first common end 201 and the third end 203 are electrically connected, the capacitance detection module 400 may obtain a first capacitance value through the first polar plate 100.

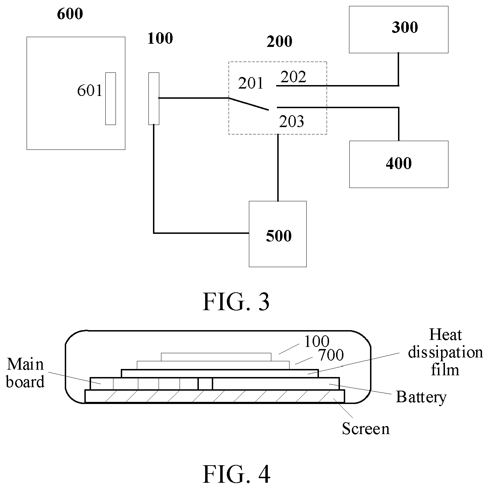

As shown in FIG. 3, the circuit switching module 500 may be connected to the first polar plate 100. The connection status of the first switch 200 may be determined according to a capacitance value of the electronic device and the external dielectric object detected by the first polar plate 100. That is, according to the capacitance value detected by the first polar plate 100, it is determined that the first common end 201 and the second end 202 of the first switch 200 are electrically connected or the first common end 201 and the third end 203 are electrically connected. According to a formula $C = \frac{k*S*\varepsilon}{h}$, a change in the capacitance value detected by the first polar plate 100 may vary according to a different dielectric constant of the external dielectric object, where C is the capacitance value between the first polar plate 100 and the external dielectric object, S is an area of the first polar plate 100 facing the external dielectric object, k is an electrostatic force constant, $\varepsilon$ is the dielectric constant of the external dielectric object, and h is the distance between the first polar plate 100 and the external dielectric object. Therefore, in a case that the capacitance value detected by the first polar plate 100 is greater than a preset capacitance threshold (that is, it is detected that an external dielectric object is close to the electronic device), whether the external dielectric object close to the electronic device is the charging device 600 (for example, a wireless charging base) is determined according to the capacitance value detected by the first polar plate 100. If it is determined that the external dielectric object is the charging device 600, the circuit switching module 500 may control the first common end 201 to be electrically connected to the second end 202. That is, the charging control module 300 may form a wireless charging loop through the first polar plate 100 and the second polar plate 601 of the charging device 600, to wirelessly charge the electronic device, which can improve the efficiency and safety of wireless charging.

On the contrary, if it is determined that the external dielectric object is not the charging device 600, the circuit switching module 500 may control the first common end 201 and the third end 203 of the first switch 200 to be electrically connected. That is, the capacitance detection module 400 may detect a first capacitance value between the first polar plate 100 and the external dielectric object.

Alternatively, the circuit switching module 500 may be connected to a processor of the electronic device, and may determine the connection status of the first switch 200 according to a switching control signal sent by the processor.

In addition, there are various methods for the circuit switching module 500 to determine the connection status of the first switch 200, which may vary according to different actual application scenarios, and are not specifically limited in the embodiments of the present invention.

An embodiment of the present invention provides a circuit control apparatus. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device; and in a case that the first common end and the third end are electrically connected, the capacitance detection module obtains a first capacitance value through the first polar plate. By using the circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

An embodiment of the present invention provides another circuit control apparatus. The circuit control apparatus includes all the functional units of the circuit control apparatus shown in FIG. 1 to FIG. 3, based on which improvement is made. The improvement is as follows:

As shown in FIG. 4, the circuit control apparatus further includes a first shielding structural member 700. The first polar plate 100 and the first shielding structural member 700 are spaced apart and distributed opposite to each other. The first shielding structural member 700 is electrically connected to the capacitance detection module 400. In a case that the first common end 201 and the third end 203 are electrically connected, the capacitance detection module 400 obtains the first capacitance value through the first polar plate 100 and the first shielding structural member 700.

The first shielding structural member 700 may be configured to shield the interference of other objects on the first polar plate 100 to improve the detection accuracy of the capacitance detection module 400. Therefore, an area of the first shielding structural member 700 facing the first polar plate 100 needs to be greater than or equal to the area of the first polar plate 100 facing the external dielectric object. In addition, the distance between the first polar plate 100 and the first shielding structural member 700 is not specifically limited in the embodiments of the present invention.

For example, as shown in FIG. 4, the first polar plate 100 may be located on the back surface of the electronic device, the first shielding structural member 700 may be located on a side of a heat dissipation film, the first polar plate 100 and the first shielding structural member 700 may be spaced apart and distributed opposite to each other, and an area of the first shielding structural member 700 may be larger than that of the first polar plate 100. When another object is close to the screen side of the electronic device (that is, the front of the electronic device), the first shielding structural member 700 may be configured to shield the interference of the object on the first polar plate 100.

In addition, the first polar plate 100 may further include a transmitting coil, and the transmitting coil may also be configured to detect the capacitance change between the external dielectric object and the electronic device. In addition, in a case that the second polar plate 601 of the charging device 600 includes a receiving coil, the transmitting coil in the first polar plate 100 may also form a charging loop with the receiving coil of the charging device 600, to charge the electronic device.

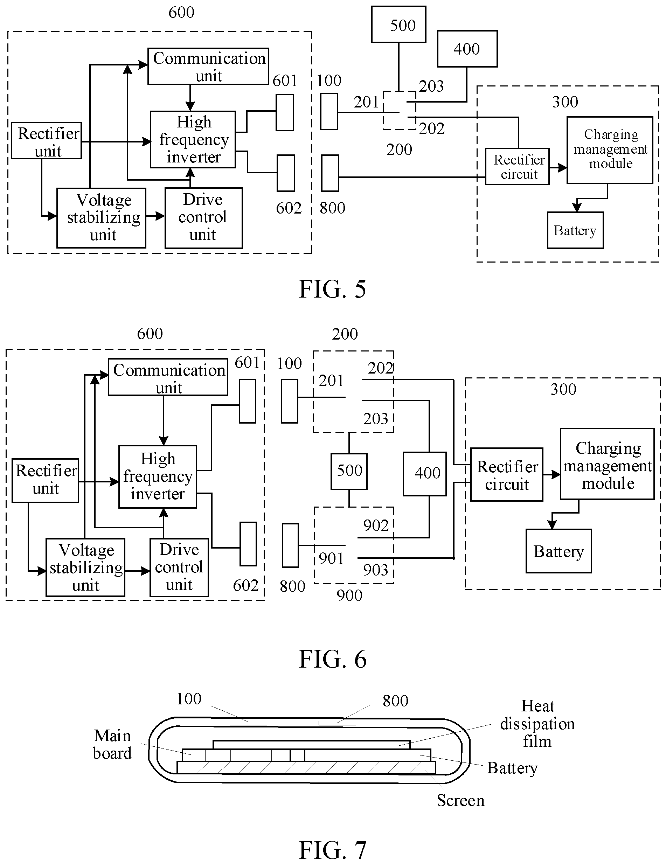

As shown in FIG. 5, the circuit control apparatus further includes a third polar plate 800. The third polar plate 800 is electrically connected to the charging control module 300. In a case that the first common end 201 and the second end 202 are electrically connected, the charging control module 300 performs wireless charging through the first polar plate 100, the third polar plate 800, the second polar plate 601 of the charging device 600, and a fourth polar plate 602 of the charging device 600.

In a case that the first polar plate 100 is a capacitor polar plate, in order to enable a wireless charging function, the electronic device needs to be equipped with a wireless charging capacitor polar plate corresponding to the charging device 600. Therefore, the circuit control apparatus may further include the third polar plate 800. The third polar plate 800 and the first polar plate 100 may both be wireless charging capacitor polar plates.

For example, assuming that the charging device 600 includes two receiving capacitor polar plates (or two receiving coils), that is, the second polar plate 601 and the fourth polar plate 602 of the charging device 600, correspondingly, the electronic device also needs to be equipped with two transmitting capacitor polar plates (or two transmitting coils). In a case that the first polar plate 100 is a capacitance detection polar plate (that is, a transmitting capacitor polar plate), the circuit control apparatus may further include the third polar plate 800. In addition, in a case that the first common end 201 and the second end 202 are electrically connected, the first polar plate 100 and the third polar plate 800 may form a wireless charging loop with the second polar plate 601 of the charging device 600 and the fourth polar plate 602 of the charging device 600, to wirelessly charge the electronic device.

As shown in FIG. 5, during wireless charging, the first polar plate 100 and the third polar plate 800 (that is, the transmitting capacitor polar plates) may correspond to the two receiving capacitor polar plates (that is, the second polar plate 601 and the fourth polar plate 602) included in the charging device 600. Two bipolar polar plates can achieve the effect of capacitors during wireless charging, and the four polar plates can form two capacitors, so that a wireless charging loop is formed between the charging device 600 and the electronic device. When the transmitting capacitor polar plates (that is, the first polar plate 100 and the third polar plate 800) obtain the energy transmitted from the receiving capacitor polar plates (that is, the second polar plate 601 and the fourth polar plate 602 of the charging device 600), the obtained voltage may be converted, through a rectifier circuit in the charging control module 300, into a voltage that can be received when the electronic device is charged, and the voltage is then transmitted, through the charging management module, to a battery connected to the charging control module 300, that is, the wireless charging of the electronic device is completed.

In addition, as shown in FIG. 6, the circuit control apparatus may further include a second switch 900. The second switch 900 includes a second common end 901, a fourth end 902, and a fifth end 903. The third polar plate 800 may be electrically connected to the second common end 901. The fourth end 902 is electrically connected to the charging control module 300. The fifth end 903 is electrically connected to the capacitance detection module 400.

In a case that the first common end 201 and the second end 202 are electrically connected, and the second common end 901 and the fourth end 902 are electrically connected, the charging control module 300 performs wireless charging through the first polar plate 100, the third polar plate 800, the second polar plate 601 of the charging device 600, and the fourth polar plate 602 of the charging device 600.

In a case that the second common end 901 and the fifth end 903 are electrically connected, the capacitance detection module 400 obtains a second capacitance value through the third polar plate 800.

The circuit control apparatus may further include a second shielding structural member. The third polar plate 800 and the second shielding structural member may be spaced apart and distributed opposite to each other, and the second shielding structural member is electrically connected to the capacitance detection module 400.

In a case that the second common end 901 and the fifth end 903 are electrically connected, the capacitance detection module 400 may obtain the second capacitance value through the third polar plate 800 and the second shielding structural member.

As shown in FIG. 7, the first polar plate 100 and the third polar plate 800 may be embedded in a casing of the electronic device, to reduce the stacking of devices and save the use space in the electronic device.

The capacitance detection module 400 may include a capacitance detection sensor. The capacitance detection sensor may be connected to the first polar plate 100 in a case that the first common end 201 and the third end 203 are electrically connected, to detect the first capacitance value between the first polar plate 100 and the external dielectric object.

As shown in FIG. 6, the circuit switching module 500 may be connected to the first switch 200, the second switch 900, and the capacitance detection module 400. The circuit switching module 500 is configured to control connection statuses of the first switch 200 and the second switch 900 according to the first capacitance value and/or the second capacitance value detected by the capacitance detection module 400.

The circuit switching module 500 may further include a data processing unit. The data processing unit may be configured to determine a digital signal for controlling the connection statuses of the first switch 200 and the second switch 900 according to the first capacitance value.

The capacitance detection module 400 may be connected to the circuit switching module 500. In a case that the circuit control apparatus includes the first switch 200 and the second switch 900, during initialization, the first common end 201 and the third end 203 of the first switch 200 may be electrically connected, and/or the second common end 901 and the fifth end 903 of the second switch 900 may be electrically connected, so that the capacitance detection module 400 obtains the first capacitance value through the first polar plate 100, and/or obtains the second capacitance value through the third polar plate 800. That is, when the external dielectric object is close to the electronic device, the capacitance detection module 400 may detect a corresponding voltage change. The data processing unit in the circuit switching module 500 may then convert a voltage change value detected by the capacitance detection sensor into a capacitance value (including the first capacitance value and/or the second capacitance value), and determine, according to the capacitance value, the digital signal for controlling the first switch 200 and the second switch 900.

For example, if it may be determined according to the first capacitance value or the second capacitance value that the external dielectric object close to the electronic device is the charging device 600, the circuit switching module 500 may electrically connect the first common end 201 and the second end 202 of the first switch 200, and control the second common end 901 and the fourth end 902 of the second switch 900 to be electrically connected. That is, the charging control module 300 may form a wireless loop with the second polar plate 601 and the fourth polar plate 602 of the charging device 600 through the first polar plate 100 and the third polar plate 800. A communication unit in the charging device 600 may be electrically connected to the electronic device. After the electric connection succeeds, the first polar plate 100 and the third polar plate 800 may form a wireless charging loop with the charging device 600, to wirelessly charge the electronic device.

If no current signal is detected in the charging control module 300 within a preset detection time, or a charging end signal of the charging control module 300 is detected, the first common end 201 and the third end 203 of the first switch 200 may be electrically connected.

In a case that the circuit control apparatus includes the first switch 200, during initialization, the circuit switching module 500 may electrically connect the first common end 201 and the third end 203 of the first switch 200. When the external dielectric object is close to the electronic device, the data processing unit in the circuit switching module 500 may determine the digital signal for controlling the first switch 200 according to the first capacitance value between the first polar plate 100 and the external dielectric object. If it is determined according to the first capacitance value that the external dielectric object close to the electronic device is the charging device 600, the first common end 201 of the first switch 200 may be switched from the third end 203 to the second end 202 for electric connection, and a wireless charging loop may be formed through the first polar plate 100, the third polar plate 800, and the second polar plate 601 and the fourth polar plate 602 of the charging device 600, to wirelessly charge the electronic device. If no current signal is detected in the charging control module 300 within the preset detection time, the first common end 201 and the third end 203 of the first switch 200 may be electrically connected. In addition, when the charging end signal of the charging control module 300 is detected, the first common end 201 and the second end 202 of the first switch may be alternatively electrically connected.

An embodiment of the present invention provides a circuit control apparatus. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device; and in a case that the first common end and the third end are electrically connected, the capacitance detection module obtains a first capacitance value through the first polar plate. By using the circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

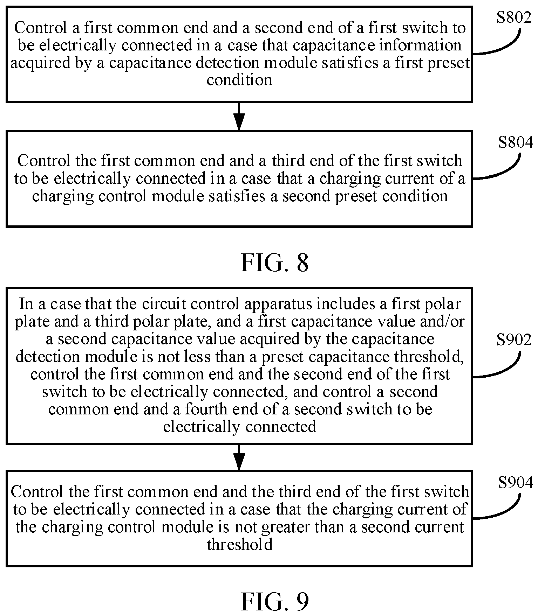

The above is a circuit control apparatus provided in an embodiment of the present invention. Based on the function and composition of the circuit control apparatus, an embodiment of the present invention further provides a circuit control method. The entity executing the method may be an electronic device. The electronic device may include the circuit control apparatus in the first embodiment and the second embodiment above. As shown in FIG. 8, the method may further include the following steps.

S802: Control a first common end and a second end of a first switch to be electrically connected in a case that capacitance information acquired by a capacitance detection module satisfies a first preset condition.

The capacitance information may be a first capacitance value obtained by the capacitance detection module through the first polar plate when the first common end and the third end of the first switch are electrically connected, or may be a change value of the first capacitance value within a preset time. Alternatively, the capacitance information may be a second capacitance value obtained by the capacitance detection module through the third polar plate when the second common end and the fifth end of the second switch are electrically connected, or may be a change value of the second capacitance value within a preset time, or the like.

In an implementation, for example, if the circuit control apparatus only includes the first polar plate, the capacitance detection module may be used to obtain the first capacitance value through the first polar plate, and the magnitude of the first capacitance value or the change value of the first capacitance value within the preset time may be detected. In a case that the magnitude of the first capacitance value or the change value of the first capacitance value within the preset time satisfies the first preset condition, the first common end and the second end of the first switch are controlled to be electrically connected. For example, when the capacitance detection module detects that the change value of the first capacitance value within the preset time is greater than a preset change threshold, the first common end and the second end of the first switch may be controlled to be electrically connected.

Alternatively, if the circuit control apparatus includes the first polar plate and the third polar plate, the first capacitance value and the second capacitance value may be obtained through the capacitance detection module. In a case that at least one of the first capacitance value or the second capacitance value satisfies the first preset condition, the first common end and the second end of the first switch are controlled to be electrically connected.

S804: Control the first common end and a third end of the first switch to be electrically connected in a case that a charging current of a charging control module satisfies a second preset condition.

The second preset condition may be that the charging current is not greater than a preset current threshold, or a preset charging condition may also be that the capacitance value is within a preset range threshold. Alternatively, the preset charging condition may be that within a predetermined time period, a capacitance change value obtained from a capacitance value of a first capacitor is greater than a preset capacitance change threshold, or the like. There may be various preset charging conditions, which may vary according to different actual application scenarios, and are not specifically limited in the embodiments of the present invention.

An embodiment of the present invention provides a circuit control method. The method may be applied to a circuit control apparatus. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device; and in a case that the first common end and the third end are electrically connected, the capacitance detection module obtains a first capacitance value through the first polar plate. By using the circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

The above is a circuit control apparatus provided in an embodiment of the present invention. Based on the function and composition of the circuit control apparatus, an embodiment of the present invention further provides a circuit control method. The entity executing the method may be an electronic device. The electronic device may include the circuit control apparatus in the first embodiment and the second embodiment above. As shown in FIG. 9, the method may further include the following steps.

S902: In a case that the circuit control apparatus includes a first polar plate and a third polar plate, and a first capacitance value and/or a second capacitance value acquired by the capacitance detection module is not less than a preset capacitance threshold, control the first common end and the second end of the first switch to be electrically connected, and control a second common end and a fourth end of a second switch to be electrically connected.

In an implementation, for example, after the first capacitance value and the second capacitance value are obtained, the first common end and the second end of the first switch may be controlled to be electrically connected in a case that the first capacitance value and/or the second capacitance value satisfy the first preset condition (for example, a change value within a predetermined time is greater than a preset change threshold), so that the charging control module forms a wireless charging loop through the first polar plate, the third polar plate, the second polar plate of the charging device, and the fourth polar plate of the charging device, to wirelessly charge the electronic device.

In addition, to ensure the accuracy of circuit control, the first capacitance value and the second capacitance value may be fused and calculated. In a case that a result of the fusion and calculation satisfies the first preset condition, the first common end and the second end of the first switch may be controlled to be electrically connected.

S904: Control the first common end and the third end of the first switch to be electrically connected in a case that the charging current of the charging control module is not greater than a preset current threshold.

In an implementation, the first common end and the third end of the first switch are controlled to be electrically connected in a case that the charging current of the charging control module is not greater than the preset current threshold within a preset detection time.

An embodiment of the present disclosure provides a circuit control method. The method may be applied to a circuit control apparatus. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device; and in a case that the first common end and the third end are electrically connected, the capacitance detection module obtains a first capacitance value through the first polar plate. By using the circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

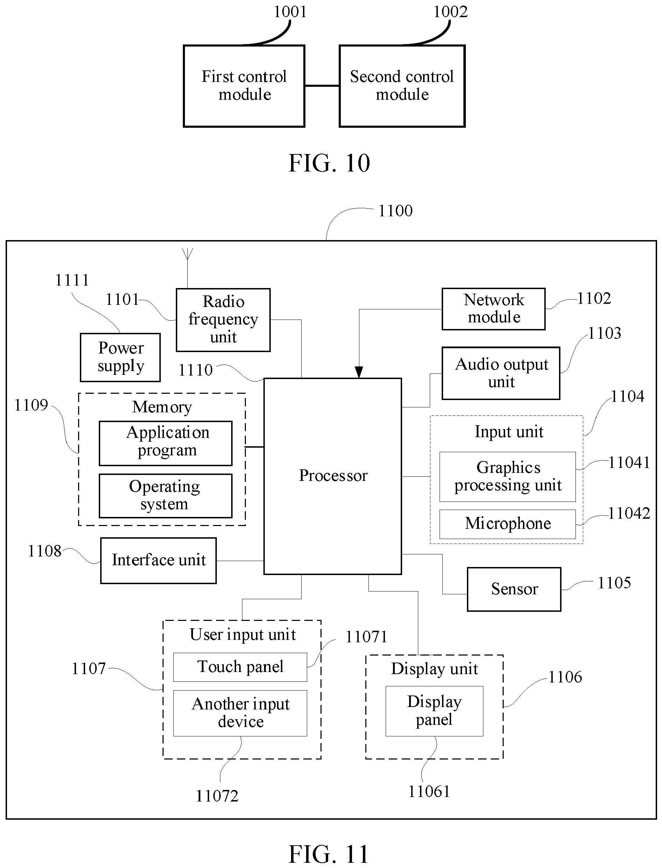

The above is the circuit control method provided in an embodiment of the present invention. Based on the same idea, an embodiment of the present invention further provides a control apparatus. As shown in FIG. 10, the control apparatus includes: a first control module 1001 and a second control module 1002, where: the first control module 1001 is configured to control a first common end and a second end of a first switch to be electrically connected in a case that capacitance information acquired by a capacitance detection module satisfies a first preset condition; and the second control module 1002 is configured to control the first common end and a third end of the first switch to be electrically connected in a case that a charging current of a charging control module satisfies a second preset condition.

In this embodiment of the present invention, the first control module 1001 is configured to: in a case that a first capacitance value and/or a second capacitance value acquired by the capacitance detection module is not less than a preset capacitance threshold, for example, a change value within a predetermined time is greater than a preset change threshold, control the first common end and the second end of the first switch to be electrically connected, and control a second common end and a fourth end of a second switch to be electrically connected.

In this embodiment of the present invention, the second control module 1002 is configured to: control the first common end and the third end of the first switch to be electrically connected in a case that the charging current of the charging control module is not greater than a preset current threshold.

In this embodiment of the present invention, the second control module 1002 is configured to: control the first common end and the third end of the first switch to be electrically connected in a case that the charging current of the charging control module is not greater than the preset current threshold within a preset detection time.

The information transmission apparatus according to this embodiment of the present invention can further perform the method performed by the electronic device in FIG. 1 to FIG. 9, and implement the functions of the electronic device in the embodiments shown in FIG. 1 to FIG. 9. Details are not described herein again.

According to the control apparatus provided in this embodiment of the present invention, a first common end and a second end of a first switch are controlled to be electrically connected in a case that capacitance information acquired by a capacitance detection module satisfies a first preset condition, and the first common end and a third end of the first switch are controlled to be electrically connected in a case that a charging current of a charging control module satisfies a second preset condition. In this way, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

FIG. 11 is a schematic diagram of a hardware structure of an electronic device according to the embodiments of the present invention. The electronic device 1100 includes, but is not limited to, components such as a radio frequency unit 1101, a network module 1102, an audio output unit 1103, an input unit 1104, a sensor 1105, a display unit 1106, a user input unit 1107, an interface unit 1108, a memory 1109, a processor 1110, and a power supply 1111. A person skilled in the art may understand that the electronic device structure shown in FIG. 11 does not constitute a limitation to the electronic device. The electronic device may include more or fewer components than those shown in the figure, or some components may be combined, or a different component deployment may be used. In the embodiments of the present invention, the electronic device includes, but is not limited to, a mobile phone, a tablet computer, a notebook computer, a handheld computer, an in-vehicle terminal, a wearable device, a pedometer, and the like.

The processor 1110 is configured to: control a first common end and a second end of a first switch to be electrically connected in a case that capacitance information acquired by a capacitance detection module satisfies a first preset condition; and control the first common end and a third end of the first switch to be electrically connected in a case that a charging current of a charging control module satisfies a second preset condition.

In addition, the processor 1110 is further configured to control the first common end and the third end of the first switch to be electrically connected in a case that the charging current of the charging control module is not greater than a preset current threshold.

In addition, the processor 1110 is further configured to control the first common end and the third end of the first switch to be electrically connected in a case that the charging current of the charging control module is not greater than the preset current threshold within a preset detection time.

An embodiment of the present invention provides an electronic device. The electronic device includes a circuit control apparatus. The circuit control apparatus includes: a charging control module, a circuit switching module, a capacitance detection module, a first switch, and a first polar plate, where the first switch includes a first common end, a second end, and a third end, the first polar plate is electrically connected to the first common end, the charging control module is electrically connected to the second end, and the capacitance detection module is electrically connected to the third end; the circuit switching module is configured to control a connection status of the first switch; in a case that the first common end and the second end are electrically connected, the charging control module performs charging through the first polar plate and a second polar plate of a charging device; and in a case that the first common end and the third end are electrically connected, the capacitance detection module obtains a first capacitance value through the first polar plate. By using the circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

It should be understood that, in the embodiments of the present invention, the radio frequency unit 1101 may be configured to receive and transmit information or receive and transmit a signal during a call. Specifically, after downlink data from a base station is received, the downlink data is sent to the processor 1110 for processing. In addition, uplink data is sent to the base station. Generally, the radio frequency unit 1101 includes, but is not limited to, an antenna, at least one amplifier, a transceiver, a coupler, a low noise amplifier, a duplexer, and the like. In addition, the radio frequency unit 1101 may further communicate with another electronic device through a wireless communication system and network.

The electronic device provides wireless broadband Internet access for a user by using the network module 1102, for example, helps the user to send and receive an email, browse a web page, and access stream media, and the like.

The audio output unit 1103 may convert audio data received by the radio frequency unit 1101 or the network module 1102 or stored in the memory 1109 into audio signals and output the audio signals as sounds. In addition, the audio output unit 1103 may further provide an audio output that is related to a particular function executed by the electronic device 1100 (for example, a call signal receiving sound or a message receiving sound). The audio output unit 1103 includes a speaker, a buzzer, a receiver, and the like.

The input unit 1104 is configured to receive an audio or video signal. The input unit 1104 may include a graphics processing unit (Graphics Processing Unit, GPU) 11041 and a microphone 11042. The graphics processing unit 11041 performs processing on image data of a static picture or a video that is obtained by an image acquisition apparatus (for example, a camera) in a video acquisition mode or an image acquisition mode. The processed image frame can be displayed on the display unit 1106. An image frame that has been processed by the graphics processing unit 11041 may be stored in the memory 1109 (or another storage medium) or sent by using the radio frequency unit 1101 or the network module 1102. The microphone 11042 can receive sounds and can process such sounds as audio data. The processed audio data may be converted, in a phone call mode, into an output in a format that can sent by the radio frequency unit 1101 to a mobile communication base station.

The electronic device 1100 further includes at least one sensor 1105, such as an optical sensor, a motion sensor, and other sensors. Specifically, the optical sensor includes an ambient light sensor and a proximity sensor. The ambient light sensor may adjust luminance of the display panel 11061 according to brightness of the ambient light. The proximity sensor may switch off the display panel 11061 and/or backlight when the electronic device 1100 is moved to the ear. As one type of motion sensor, an acceleration sensor may detect magnitude of accelerations in various directions (generally in three axes), may detect magnitude and a direction of the gravity when static, and may be configured to identify an attitude of the electronic device (for example, switchover between horizontal and vertical screens, a related game, and attitude calibration of a magnetometer), a related function of vibration identification (for example, a pedometer and a knock); The sensor 1105 may further include a fingerprint sensor, a pressure sensor, an iris sensor, a molecular sensor, a gyroscope, a barometer, a hygrometer, a thermometer, an infrared sensor, and the like, and details are not described herein again.

The display unit 1106 is configured to display information inputted by the user or information provided for the user. The display unit 1106 may include a display panel 11061. The display panel 11061 may be configured by using a liquid crystal display (LCD), an organic light-emitting diode (OLED), or the like.

The user input unit 1107 may be configured to receive input digit or character information, and generate key signal input related to the user setting and function control of the electronic device. Specifically, the user input unit 1107 includes a touch panel 11071 and another input device 11072. The touch panel 11071, also referred to as a touchscreen, may collect a touch operation of a user on or near the touch panel (for example, an operation of a user on or near the touch panel 11071 by using any suitable object or attachment, such as a finger or a stylus). The touch panel 11071 may include two parts: a touch detection apparatus and a touch controller. The touch detection apparatus detects a touch position of the user, detects a signal generated by the touch operation, and transfers the signal to the touch controller. The touch controller receives the touch information from the touch detection apparatus, converts the touch information into touch point coordinates, and transmits the touch point coordinates to the processor 1110. Moreover, the touch controller may receive and execute a command transmitted from the processor 1110. In addition, the touch panel 11071 may be implemented by using various types, such as a resistive type, a capacitive type, an infrared type, and a surface acoustic wave type. In addition to the touch panel 11071, the user input unit 1107 may further include the another input device 11072. Specifically, the another input device 11072 may include, but is not limited to, a physical keyboard, a functional key (for example, a volume control key or a switch key), a track ball, a mouse, and a joystick, which are not repeated herein.

Further, the touch panel 11071 may cover the display panel 11061. After detecting a touch operation on or near the touch panel, the touch panel 11071 transfers the touch operation to the processor 1110, to determine a type of a touch event. Then, the processor 1110 provides a corresponding visual output on the display panel 11061 according to the type of the touch event. In FIG. 11, the touch panel 11071 and the display panel 11061 implement, as two independent parts, input and output functions of the electronic device. However, in some embodiments, the touch panel 11071 and the display panel 11061 may be integrated to implement the input and output functions of the electronic device, which is not specifically limited herein.

The interface unit 1108 is an interface for connecting an external apparatus to the electronic device 1100. For example, the external apparatus may include a wired or wireless headset port, an external power supply (or battery charger) port, a wired or wireless data port, a memory card port, a port for connecting an apparatus with a recognition module, an audio input/output (I/O) port, a video I/O port, a headphone port, and the like. The interface unit 1108 may be configured to receive an input (for example, data information or electric power) from an external apparatus and transmit the received input to one or more elements in the electronic device 1100 or may be configured to transmit data between the electronic device 1100 and an external apparatus.

The memory 1109 may be configured to store a software program and various data. The memory 1109 may mainly include a program storage area and a data storage area. The program storage area may store an operating system, an application program required by at least one function (for example, a sound playback function and an image display function), and the like. The data storage area may store data (for example, audio data and a phone book) created according to use of the mobile phone. In addition, the memory 1109 may include a high speed random access memory, and may further include a non-volatile memory, such as at least one magnetic disk storage device, a flash memory or other non-volatile solid state storage devices.

The processor 1110 is a control center of the electronic device, and connects various parts of the entire electronic device by using various interfaces and lines. By running or executing the software program and/or module stored in the memory 1109, and invoking data stored in the memory 1109, the processor performs various functions of the electronic device and processes data, thereby performing overall monitoring on the electronic device. The processor 1110 may include one or more processing units. Preferably, the processor 1110 may integrate an application processor and a modem processor. The application processor mainly processes an operating system, a user interface, an application program, and the like. The modem processor mainly processes wireless communication. It may be understood that the foregoing modem processor may either not be integrated into the processor 1110.

The electronic device 1100 may further include the power supply 1111 (such as a battery) for supplying power to the components. Preferably, the power supply 1111 may be logically connected to the processor 1110 by using a power management system, thereby implementing functions such as charging, discharging, and power consumption management by using the power management system.

Preferably, an embodiment of the present invention further provides an electronic device, including a processor 1110, a memory 1109, and a computer program stored in the memory 1109 and executable on the processor 1110, where the computer program, when executed by the processor 1110, implements the processes of the embodiments of the circuit control method, and can achieve the same technical effects. To avoid repetition, details are not described herein again.

An embodiment of the present invention further provides a computer-readable storage medium storing a computer program, where the computer program, when executed by a processor, implements the processes of the embodiments of the circuit control method, and can achieve the same technical effects. To avoid repetition, details are not described herein again. The computer-readable storage medium is, for example, a read-only memory (Read-Only Memory, ROM), a random access memory (Random Access Memory, RAM), a magnetic disk, or an optical disc.

An embodiment of the present invention provides a computer-readable storage medium, based on the foregoing circuit control apparatus, according to the connection status of the first switch, the charging control module can be controlled to charge the electronic device through the first polar plate, or the capacitance detection module can be controlled to detect the first capacitance value through the first polar plate, avoiding stacking of the devices. In addition, when the charging control module charges the electronic device through the first polar plate, even if the working voltage is high, there is no safety hazard, thereby improving the safety of the electronic device.

A person skilled in the art should understand that the embodiments of the present invention may be provided as a method, a system, or a computer program product. Therefore, the present invention may be in the form of complete hardware embodiments, complete software embodiments, or embodiments combining software and hardware. Moreover, the present invention may use a form of a computer program product that is implemented on one or more computer-usable storage media (including but not limited to a disk memory, a CD-ROM, an optical memory, and the like) that include computer-usable program code.

The present invention is described with reference to the flowcharts and/or block diagrams of the method, the device (system), and the computer program product according to the embodiments of the present invention. It should be understood that computer program instructions can implement each procedure and/or block in the flowcharts and/or block diagrams and a combination of procedures and/or blocks in the flowcharts and/or block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may also be stored in a computer readable memory that can instruct a computer or any other programmable data processing device to work in a specific manner, so that the instructions stored in the computer readable memory generate an artifact that includes an instruction apparatus. The instruction apparatus implements a specific function in one or more processes in the flowcharts and/or in one or more blocks in the block diagrams.

These computer program instructions may also be loaded into a computer or another programmable data processing device, so that a series of operation steps are performed on the computer or another programmable data processing device to generate processing implemented by a computer, and instructions executed on the computer or another programmable data processing device provide steps for implementing functions specified in one or more procedures in the flowcharts and/or one or more blocks in the block diagrams.

In a typical configuration, the computer device includes one or more processors (CPUs), an input/output interface, a network interface, and a memory.

The memory may include a form such as a volatile memory, a random access memory (RAM) and/or a non-volatile memory such as a read-only memory (ROM) or a flash memory (flash RAM) in a computer-readable medium. The memory is an example of the computer-readable medium.

The computer-readable medium includes a non-volatile medium and a volatile medium, a removable medium and a non-removable medium, which may implement storage of information by using any method or technology. The information may be a computer-readable instruction, a data structure, a program module, or other data. An example of a computer storage medium includes, but is not limited to, a phase-change memory (PRAM), a static random access memory (SRAM), a dynamic random access memory (DRAM), another type of RAM, a read-only memory (ROM), an electrically erasable programmable read-only memory (EEPROM), a flash memory or another memory technology, a compact disc read-only memory (CD-ROM), a digital versatile disc (DVD) or another optical memory, a cartridge tape, a magnetic tape, a magnetic disk storage or another magnetic storage device, or any other non-transmission medium, which may be configured to store information accessible by a computing device. Based on the definition in the present invention, the computer-readable medium does not include transitory computer readable media (transitory media), such as a modulated data signal and a carrier.

It should be further noted that, the terms "include" "comprise" or any other variants are intended to cover a non-exclusive inclusion, so that a process, a method, a commodity, or a device that includes a series of elements not only includes such elements, but also includes other elements not expressly listed, or further includes elements inherent to such a process, method, commodity, or device. Unless otherwise specified, an element limited by "include a/an..." does not exclude other same elements existing in the process, the method, the commodity, or the device that includes the element.

A person skilled in the art should understand that the embodiments of the present invention may be provided as a method, a system, or a computer program product. Therefore, the present invention may be in the form of complete hardware embodiments, complete software embodiments, or embodiments combining software and hardware. Moreover, the present invention may use a form of a computer program product that is implemented on one or more computer-usable storage media (including but not limited to a disk memory, a CD-ROM, an optical memory, and the like) that include computer-usable program code.

**Claims**

1. A circuit control apparatus, the apparatus comprising: a charging control module (300), a circuit switching module (500), a capacitance detection module (400), a first switch (200), and a first polar plate (100), wherein

   the first switch (200) comprises a first common end (201), a second end (202), and a third end (203), the first polar plate (100) is electrically connected to the first common end (201), the charging control module (300) is electrically connected to the second end (202), and the capacitance detection module (400) is electrically connected to the third end (203);
   the circuit switching module (500) is configured to control a connection status of the first switch (200);
   in a case that the first common end (201) and the second end (202) are electrically connected, the charging control module (300) is configured to perform charging through the first polar plate (100) and a second polar plate (601) of a charging device (600), wherein the charging device (600) is an external dielectric object; and
   in a case that the first common end (201) and the third end (203) are electrically connected, the capacitance detection module (400) is configured to obtain a first capacitance value through the first polar plate (100);
   wherein the apparatus further comprises: a first shielding structural member (700), wherein the first polar plate (100) and the first shielding structural member (700) are spaced apart and distributed opposite to each other, and the first shielding structural member (700) is electrically connected to the capacitance detection module (400); and

in a case that the first common end (201) and the third end (203) are electrically connected, the capacitance detection module (400) is configured to obtain the first capacitance value through the first polar plate (100) and the first shielding structural member (700).

2. The apparatus according to claim 1, wherein an area of the first shielding structural member (700) facing (100) is greater than or equal to an area of the first polar plate (100) facing the external dielectric object.

3. The apparatus according to claim 1, further comprising a third polar plate (800), wherein the third polar plate (800) is electrically connected to the charging control module (300); and

in a case that the first common end (201) and the second end (202) are electrically connected, the charging control module (300) is configured to perform wireless charging through the first polar plate (100), the third polar plate (800), the second polar plate (601) of the charging device (600), and a fourth polar plate (602) of the charging device (600).

4. The apparatus according to claim 3, further comprising a second switch (900), wherein

the second switch (900) comprises a second common end (901), a fourth end (902), and a fifth end (903), the third polar plate (800) is electrically connected to the second common end (901), the fourth end (902) is electrically connected to the charging control module (300), and the fifth end (903) is electrically connected to the capacitance detection module (400);

in a case that the first common end (201) and the second end (202) are electrically connected, and the second common end (901) and the fourth end (902) are electrically connected, the charging control module (300) is configured to perform wireless charging through the first polar plate (100), the third polar plate (800), the second polar plate (601) of the charging device (600), and the fourth polar plate (602) of the charging device (600); and

in a case that the second common end (901) and the fifth end (903) are electrically connected, the capacitance detection module (400) is configured to obtain a second capacitance value through the third polar plate (800).

5. The apparatus according to claim 4, further comprising a second shielding structural member, wherein the third polar plate (800) and the second shielding structural member are spaced apart and distributed opposite to each other, and the second shielding structural member is electrically connected to the capacitance detection module (400); and

in a case that the second common end (901) and the fifth end (903) are electrically connected, the capacitance detection module (400) is configured to obtain the second capacitance value through the third polar plate (800) and the second shielding structural member.

6. The apparatus according to claim 5, wherein the circuit switching module (500) is connected to the first switch (200), the second switch (900), and the capacitance detection module (400), and the circuit switching module (500) is configured to control connection statuses of the first switch (200) and the second switch (900) according to the first capacitance value and/or the second capacitance value detected by the capacitance detection module (400).

7. A circuit control method, applied to the circuit control apparatus according to any one of claims 1 to 6, the method comprising

controlling (S802) a first common end and a second end of a first switch to be electrically connected in a case that capacitance information acquired by a capacitance detection module satisfies a first preset condition; and controlling (S804) the first common end and a third end of the first switch to be electrically connected in a case that a charging current of a charging control module satisfies a second preset condition.

8. The method according to claim 7, wherein the controlling (S802) a first common end and a second end of a first switch to be electrically connected in a case that capacitance information acquired by a capacitance detection module satisfies a first preset condition comprises:
in a case that the circuit control apparatus comprises a first polar plate and a third polar plate, and a first capacitance value and/or a second capacitance value acquired by the capacitance detection module is not less than a preset capacitance threshold, controlling (S902) the first common end and the second end of the first switch to be electrically connected, and controlling a second common end and a fourth end of a second switch to be electrically connected.

9. The method according to claim 7, wherein the controlling (S804) the first common end and a third end of the first switch to be electrically connected in a case that a charging current of a charging control module satisfies a second preset condition comprises:
controlling (S904) the first common end and the third end of the first switch to be electrically connected in a case that the charging current of the charging control module is not greater than a preset current threshold.

10. The method according to claim 9, wherein the controlling the first common end and the third end of the first switch to be electrically connected in a case that the charging current of the charging control module is not greater than a preset current threshold comprises:

controlling the first common end and the third end of the first switch to be electrically connected in a case that the charging current of the charging control module is not greater than the preset current threshold within a preset detection time.

11. An electronic device (1100), **characterized by** comprising the apparatus according to any one of claims 1 to 6.

**Patentansprüche**

1. Schaltungssteuervorrichtung, wobei die Vorrichtung umfasst: ein Ladesteuermodul (300), ein Stromkreisschaltmodul (500), ein Kapazitätserkennungsmodul (400), einen ersten Schalter (200) und eine erste Polarplatte (100), wobei

der erste Schalter (200) ein erstes gemeinsames Ende (201), ein zweites Ende (202) und ein drittes Ende (203) umfasst, die erste Polarplatte (100) elektrisch mit dem ersten gemeinsamen Ende (201) verbunden ist, das Ladesteuermodul (300) elektrisch mit dem zweiten Ende (202) verbunden ist, und das Kapazitätserkennungsmodul (400) elektrisch mit dem dritten Ende (203) verbunden ist;
das Schaltungsumschaltmodul (500) dazu konfiguriert ist, einen Verbindungsstatus des ersten Schalters (200) zu steuern,
in einem Fall, in dem das erste gemeinsame Ende (201) und das zweite Ende (202) elektrisch verbunden sind, das Ladesteuermodul (300) dazu konfiguriert ist, Laden über die erste Polarplatte (100) und eine zweite Polarplatte (601) einer Ladeeinrichtung (600) durchzuführen, wobei die Ladeeinrichtung (600) ein externes dielektrisches Objekt ist; und
in einem Fall, in dem das erste gemeinsame Ende (201) und das dritte Ende (203) elektrisch verbunden sind, das Kapazitätserkennungsmodul (400) dazu konfiguriert ist, über die erste Polarplatte (100) einen ersten Kapazitätswert zu erhalten,
wobei die Vorrichtung ferner umfasst: ein erstes Abschirmungsstrukturelement (700), wobei die erste Polarplatte (100) und das erste Abschirmungsstrukturelement (700) voneinander beabstandet und zueinander entgegengesetzt verteilt sind und das erste Abschirmungsstrukturelement (700) mit dem Kapazitätserkennungsmodul (400) elektrisch verbunden ist; und
in einem Fall, in dem das erste gemeinsame Ende (201) und das dritte Ende (203) elektrisch verbunden sind, das Kapazitätserkennungsmodul (400) dazu konfiguriert ist, über die erste Polarplatte (100) und das erste Abschirmungsstrukturelement (700) den ersten Kapazitätswert zu erhalten.

2. Vorrichtung nach Anspruch 1, wobei eine (100) zugewandte Fläche des ersten Abschirmungsstrukturelements (700) größer als oder gleich groß wie eine dem externen dielektrischen Objekt zugewandte Fläche der ersten Polarplatte (100) ist.

3. Vorrichtung nach Anspruch 1, ferner umfassend eine dritte Polarplatte (800), wobei die dritte Polarplatte (800) elektrisch mit dem Ladesteuermodul (300) verbunden ist, und

in einem Fall, in dem das erste gemeinsame Ende (201) und das zweite Ende (202) elektrisch verbunden sind, das Ladesteuermodul (300) dazu konfiguriert ist, drahtloses Laden über die erste Polarplatte (100), die dritte Polarplatte (800), die zweite Polarplatte (601) der Ladeeinrichtung (600) und eine vierte Polarplatte (602) der Ladeeinrichtung (600) durchzuführen.

4. Vorrichtung nach Anspruch 3, ferner umfassend einen zweiten Schalter (900), wobei

der zweite Schalter (900) ein zweites gemeinsames Ende (901), ein viertes Ende (902) und ein fünftes Ende (903) umfasst, wobei die dritte Polarplatte (800) elektrisch mit dem zweiten gemeinsamen Ende (901) verbunden ist, das vierte Ende (902) elektrisch mit dem Ladesteuermodul (300) verbunden ist, und das fünfte Ende (903) elektrisch mit dem Kapazitätserkennungsmodul (400) verbunden ist;
in einem Fall, in dem das erste gemeinsame Ende (201) und das zweite Ende (202) elektrisch verbunden sind, und das zweite gemeinsame Ende (901) und das vierte Ende (902) elektrisch verbunden sind, das Ladesteuermodul (300) dazu konfiguriert ist, drahtloses Laden über die erste Polarplatte (100), die dritte Polarplatte (800), die zweite Polarplatte (601) der Ladeeinrichtung (600) und die vierte Polarplatte (602) der Ladeeinrichtung (600) durchzuführen, und
in einem Fall, in dem das zweite gemeinsame Ende (901) und das fünfte Ende (903) elektrisch verbunden sind, das Kapazitätserkennungsmodul (400) dazu konfiguriert ist, über die dritte Polarplatte (800) einen zweiten Kapazitätswert zu erhalten.

5. Vorrichtung nach Anspruch 4, ferner umfassend ein zweites Abschirmungsstrukturelement, wobei die dritte Polarplatte (800) und das zweite Abschirmungsstrukturelement voneinander beabstandet und zueinander entgegengesetzt verteilt sind und das zweite Abschirmungsstrukturelement mit dem Kapazitätserkennungsmodul (400) elektrisch verbunden ist, und
in einem Fall, in dem das zweite gemeinsame Ende (901) und das fünfte Ende (903) elektrisch verbunden sind, das Kapazitätserkennungsmodul (400) dazu konfiguriert ist, über die dritte Polarplatte (800) und das zweite Abschirmungsstrukturelement den zweiten Kapazitätswert zu erhalten.

6. Vorrichtung nach Anspruch 5, wobei das Schaltungsumschaltmodul (500) mit dem ersten Schalter (200), dem zweiten Schalter (900) und dem Kapazitätserkennungsmodul (400) verbunden ist, und das Schaltungsumschaltmodul (500) dazu konfiguriert ist, Verbindungsstatus des ersten Schalters (200) und des zweiten Schalters (900) entsprechend dem ersten Kapazitätswert und/oder dem zweiten Kapazitätswert, erkannt vom Kapazitätserkennungsmodul (400), zu steuern.

7. Schaltungssteuerverfahren, angewendet auf die Schaltungssteuervorrichtung nach einem der Ansprüche 1 bis 6, wobei das Verfahren umfasst:

   Steuern (S802) eines ersten gemeinsamen Endes und eines zweiten Endes eines ersten Schalters, sodass diese in einem Fall, in dem von einem Kapazitätserkennungsmodul beschaffte Kapazitätsinformationen einer ersten voreingestellten Bedingung entsprechen, elektrisch verbunden werden, und
   Steuern (S804) des ersten gemeinsamen Endes und eines dritten Endes des ersten Schalters, sodass diese in einem Fall, in dem ein Ladestrom eines Ladesteuermoduls einer zweiten voreingestellten Bedingung entspricht, elektrisch verbunden werden.

8. Verfahren nach Anspruch 7, wobei das Steuern (S802) eines ersten gemeinsamen Endes und eines zweiten Endes eines ersten Schalters, sodass diese in einem Fall, in dem von einem Kapazitätserkennungsmodul beschaffte Kapazitätsinformationen einer ersten voreingestellten Bedingung entsprechen, elektrisch verbunden werden, umfasst:
   in einem Fall, in dem die Schaltungssteuervorrichtung eine erste Polarplatte und eine dritte Polarplatte umfasst, und ein erste Kapazitätswert und/oder ein zweiter Kapazitätswert, die von dem Kapazitätserkennungsmodul beschafft wurden, nicht unter einem voreingestellten Kapazitätsschwellenwert liegen, Steuern (S902) des ersten gemeinsamen Endes und des zweiten Endes des ersten Schalters, sodass diese elektrisch verbunden werden, und Steuern eines zweiten gemeinsamen Endes und eines vierten Endes eines zweiten Schalters, sodass diese elektrisch verbunden werden.

9. Verfahren nach Anspruch 7, wobei das Steuern (S804) des ersten gemeinsamen Endes und eines dritten Endes des ersten Schalters, sodass diese in einem Fall, in dem ein Ladestrom eines Ladesteuermoduls einer zweiten voreingestellten Bedingung entspricht, elektrisch verbunden werden, umfasst:
   Steuern (S904) des ersten gemeinsamen Endes und des dritten Endes des ersten Schalters, sodass diese in einem Fall, in dem der Ladestrom des Ladesteuermoduls nicht größer als ein voreingestellter Stromschwellenwert ist, elektrisch verbunden werden.

10. Verfahren nach Anspruch 9, wobei das Steuern des ersten gemeinsamen Endes und des dritten Endes eines ersten Schalters, sodass diese in einem Fall, in dem der Ladestrom des Ladesteuermoduls nicht größer als ein voreingestellter Stromschwellenwert ist, elektrisch verbunden werden, umfasst:
   Steuern des ersten gemeinsamen Endes und des dritten Endes des ersten Schalters, sodass diese in einem Fall, in dem der Ladestrom des Ladesteuermoduls innerhalb einer voreingestellten Erkennungszeit nicht größer als der voreingestellte Stromschwellenwert ist, elektrisch verbunden werden.

11. Elektronische Einrichtung (1100), **dadurch gekennzeichnet, dass** sie die Vorrichtung nach einem der Ansprüche 1 bis 6 umfasst.

**Revendications**

1. Appareil de commande de circuit, l'appareil comprenant : un module de commande de charge (300), un module de commutation de circuit (500), un module de détection de capacité (400), un premier interrupteur (200), et une première plaque polaire (100), dans lequel

   le premier interrupteur (200) comprend une première extrémité commune (201), une deuxième extrémité (202), et une troisième extrémité (203), la première plaque polaire (100) est connectée électriquement à la première extrémité commune (201), le module de commande de charge (300) est connecté électriquement à la deuxième extrémité (202), et le module de détection de capacité (400) est connecté électriquement à la troisième extrémité (203) ;

le module de commutation de circuit (500) est configuré pour commander un état de connexion du premier interrupteur (200),

au cas où la première extrémité commune (201) et la deuxième extrémité (202) sont connectées électriquement, le module de commande de charge (300) est configuré pour produire une charge à travers la première plaque polaire (100) et une deuxième plaque polaire (601) d'un dispositif de charge (600), dans lequel le dispositif de charge (600) est un objet diélectrique externe ; et

au cas où la première extrémité commune (201) et la troisième extrémité (203) sont connectées électriquement, le module de détection de capacité (400) est configuré pour obtenir une première valeur de capacité à travers la première plaque polaire (100) ;

dans lequel l'appareil comprend en outre : un premier élément structurel de blindage (700), dans lequel la première plaque polaire (100) et le premier élément structurel de blindage (700) sont espacés et distribués à l'opposé l'un de l'autre, et le premier élément structurel de blindage (700) est électriquement connecté au module de détection de capacité (400) ; et

au cas où la première extrémité commune (201) et la troisième extrémité (203) sont connectées électriquement, le module de détection de capacité (400) est configuré pour obtenir la première valeur de capacité à travers la première plaque polaire (100) et le premier élément structurel de blindage (700).

2.  Appareil selon la revendication 1, dans lequel une zone du premier élément structurel de blindage (700) faisant face à (100) est supérieure ou égale à une zone de la première plaque polaire (100) faisant face à l'objet diélectrique externe.

3.  Appareil selon la revendication 1, comprenant en outre une troisième plaque polaire (800), dans laquelle la troisième plaque polaire (800) est électriquement connectée au module de commande de charge (300) ; et.
au cas où la première extrémité commune (201) et la deuxième extrémité (202) sont électriquement connectées, le module de commande de charge (300) est configuré pour produire une charge sans fil à travers la première plaque polaire (100), la troisième plaque polaire (800), la deuxième plaque polaire (601) du dispositif de charge (600), et une quatrième plaque polaire (602) du dispositif de charge (600).

4.  Appareil selon la revendication 3, comprenant en outre un deuxième interrupteur (900), dans lequel le deuxième interrupteur (900) comprend une deuxième extrémité commune (901), une quatrième extrémité (902), et une cinquième extrémité (903), la troisième plaque polaire (800) est connectée électriquement à la deuxième extrémité commune (901), la quatrième extrémité (902) est connectée électriquement au module de contrôle de charge (300), et la cinquième extrémité (903) est connectée électriquement au module de détection de capacité (400) ;

au cas où la première extrémité commune (201) et la deuxième extrémité (202) sont connectées électriquement, et la deuxième extrémité commune (901) et la quatrième extrémité (902) sont connectées électriquement, le module de commande de charge (30) est configuré pour produire une charge sans fil à travers la première plaque polaire (100), la troisième plaque polaire (800), la deuxième plaque polaire (601) du dispositif de charge (600), et la quatrième plaque polaire (602) du dispositif de charge (600), et au cas où le module de commande de charge (30) est configuré pour produire une charge sans fil à travers la première plaque polaire (100), la troisième plaque polaire (800), la deuxième plaque polaire (601) du dispositif de charge (600).
au cas où la deuxième extrémité commune (901) et la cinquième extrémité (903) sont connectées électriquement, le module de détection de capacité (400) est configuré pour obtenir une deuxième valeur de capacité par l'intermédiaire de la troisième plaque polaire (800).

5.  Appareil selon la revendication 4, comprenant en outre un deuxième élément structurel de blindage, dans lequel la troisième plaque polaire (800) et le deuxième élément structurel de blindage sont espacés et répartis à l'opposé l'un de l'autre, et le deuxième élément structurel de blindage est connecté électriquement au module de détection de capacité (400) ; et.
au cas où la deuxième extrémité commune (901) et la cinquième extrémité (903) sont connectées électriquement, le module de détection de capacité (400) est configuré pour obtenir la deuxième valeur de capacité par l'intermédiaire de la troisième plaque polaire (800) et du deuxième élément structurel de blindage.

6.  Appareil selon la revendication 5, dans lequel le module de commutation de circuit (500) est connecté au premier commutateur (200), au deuxième commutateur (900) et au module de détection de capacité (400), et le module de commutation de circuit (500) est configuré pour commander les états de connexion du premier commutateur (200) et du deuxième commutateur (900) en fonction de la première valeur de capacité et/ou de la deuxième valeur de capacité détectée par le module de détection de capacité (400).

7. Procédé de commande de circuit, appliqué à l'appareil de commande de circuit selon l'une quelconque des revendications 1 à 6, le procédé comprenant :

la commande (S802) d'une première extrémité commune et d'une deuxième extrémité d'un premier interrupteur à connecter électriquement dans un cas où les informations de capacité acquises par un module de détection de capacité satisfont à une première condition prédéfinie, et commander (S804) la première extrémité commune et une troisième extrémité du premier interrupteur pour qu'elles soient connectées électriquement au cas où un courant de charge d'un module de commande de charge satisfait à une deuxième condition prédéfinie.

8. Procédé selon la revendication 7, dans lequel la commande (S802) d'une première extrémité commune et d'une deuxième extrémité d'un premier interrupteur à connecter électriquement au cas où les informations de capacité acquises par un module de détection de capacité satisfont à une première condition prédéfinie comprend :

au cas où l'appareil de commande de circuit comprend une première plaque polaire et une troisième plaque polaire, et une première valeur de capacité et/ou une deuxième valeur de capacité acquise par le module de détection de capacité n'est pas inférieure à un seuil de capacité prédéfini, commander (S902) la première extrémité commune et la deuxième extrémité du premier interrupteur pour qu'elles soient connectées électriquement, et commander une deuxième extrémité commune et une quatrième extrémité d'un deuxième interrupteur pour qu'elles soient connectées électriquement.

9. Procédé selon la revendication 7, dans lequel la commande (S804) de la première extrémité commune et d'une troisième extrémité du premier interrupteur à connecter électriquement au cas où un courant de charge d'un module de commande de charge satisfait à une deuxième condition prédéfinie comprend :
la commande (S904) de la première extrémité commune et de la troisième extrémité du premier interrupteur pour qu'elles soient connectées électriquement au cas où le courant de charge du module de commande de charge n'est pas supérieur à un seuil de courant prédéfini.

10. Procédé selon la revendication 9, dans lequel la commande de la première extrémité commune et de la troisième extrémité du premier interrupteur pour qu'elles soient connectées électriquement au cas où le courant de charge du module de commande de charge n'est pas supérieur à un seuil de courant prédéfini comprend :
la commande de la première extrémité commune et la troisième extrémité du premier interrupteur pour qu'elles soient connectées électriquement au cas où le courant de charge du module de commande de charge n'est pas supérieur au seuil de courant prédéfini dans un temps de détection prédéfini.

11. Dispositif électronique (1100), **caractérisé en ce qu'**il comprend l'appareil selon l'une quelconque des revendications 1 à 6.

**600**

**100**

**200**

**300**

**601**

**201**    **202**

**203**

**500**

**400**

FIG. 1

100

FIG. 2

**600**

**100**   **200**   **300**

601   201   202

203

**400**

**500**

## FIG. 3

100
700

Main
board

Heat
dissipation
film

Battery

Screen

## FIG. 4

FIG. 5

FIG. 6

FIG. 7

EP 4 113 778 B1

Control a first common end and a second end of a first switch to be electrically connected in a case that capacitance information acquired by a capacitance detection module satisfies a first preset condition

S802

Control the first common end and a third end of the first switch to be electrically connected in a case that a charging current of a charging control module satisfies a second preset condition

S804

FIG. 8

In a case that the circuit control apparatus includes a first polar plate and a third polar plate, and a first capacitance value and/or a second capacitance value acquired by the capacitance detection module is not less than a preset capacitance threshold, control the first common end and the second end of the first switch to be electrically connected, and control a second common end and a fourth end of a second switch to be electrically connected

S902

Control the first common end and the third end of the first switch to be electrically connected in a case that the charging current of the charging control module is not greater than a second current threshold

S904

FIG. 9

23

1001          1002

| First control module | Second control module |

FIG. 10

1100

1111
1101        Radio frequency unit        Network module    1102

1103
Power supply        Audio output unit

1110
1109
Memory                                         Input unit    1104

Application program              Graphics processing unit    11041

Processor
Operating system                    Microphone    11042

1108    Interface unit

Sensor    1105

User input unit        11071

1107    Touch panel

Display unit
Another input device        Display panel    1106

11072        11061

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120235508 A1

- CN 106569648 A